# EUROPEAN PATENT SPECIFICATION

(11) **EP 3 492 441 B1**
(45) Date of publication and mention of the grant of the patent: **16.10.2024**
(21) Application number: 17834474.3
(22) Date of filing: 27.07.2017
(51) Int. Cl.: C04B 37/02, H01L 23/13, H01L 23/36, H05K 1/02, H05K 3/34, H01L 23/15, H01L 23/373, H05K 1/03, H05K 3/38

(54) **JOINED BODY, CIRCUIT BOARD AND SEMICONDUCTOR DEVICE**
VERBUNDENER KÖRPER, LEITERPLATTE UND HALBLEITERBAUELEMENT
CORPS LIÉ, CARTE DE CIRCUIT IMPRIMÉ ET DISPOSITIF À SEMI-CONDUCTEURS

(30) Priority: 28.07.2016 JP 2016148105
(43) Date of publication of application: 05.06.2019
(73) Proprietor: Kabushiki Kaisha Toshiba, Minato-ku Tokyo 105-8001 (JP); Toshiba Materials Co., Ltd., Yokohama-shi, Kanagawa 235-8522 (JP)
(72) Inventor: UMEHARA Masashi, Yokohama-shi, Kanagawa (JP); KATO Hiromasa, Yokohama-shi, Kanagawa (JP); NABA Takayuki, Yokohama-shi, Kanagawa (JP)
(74) Representative: Henkel & Partner mbB
(86) International application number: PCT/JP2017/027239
(87) International publication number: WO 2018/021472

(56) References cited:
- EP-A1- 3 358 614
- WO-A1-2010/137651
- WO-A1-2011/034075
- US-A1- 2012 080 216
- US-A1- 2012 168 209
- US-A1- 2014 291 699
- US-A1- 2015 257 252

## Description

### FIELD

The invention relates to a joined body, a circuit board, and a semiconductor device.

### BACKGROUND

In recent years, with a performance improvement of industrial apparatuses, the outputs of power modules mounted thereon have been becoming higher. Accordingly, the outputs of semiconductor elements have been becoming higher. Operation guaranteed temperatures of semiconductor elements are 125°C to 1 50°C, and it is expected that the operation guaranteed temperatures will increase to 1 75°C or more in the future.

The increase in the operation guaranteed temperatures of semiconductor elements requires that ceramic metal circuit boards should have high thermal cycle test (TCT) characteristics. The TCT is a test to measure durability of a ceramic metal circuit board by setting low temperature → room temperature → high temperature → room temperature as one cycle.

One example of conventional ceramic metal circuit boards has a brazing material protruding portion having no void therein. An example using a silicon nitride substrate has 5000 cycle-durability. By eliminating the void in the brazing material protruding portion, it is possible to improve the TCT characteristics. However, with the performance improvement of semiconductor elements, it is expected that the operation guaranteed temperature will increase to 175°C.

The case where the operation guaranteed temperature is 175°C or more has difficulty in sufficiently improving the TCT characteristics by merely eliminating the void in the protruding portion. This is conceivably due to the hardness of a joining layer.

Examples of a conventional brazing material include a brazing material made of 67 mass% of Ag-20 mass% of Cu-10 mass% of Sn-3 mass% of Ti in a joining layer. The Ag-Cu-based brazing material is an example using an AgCu eutectic, and thus Ag and Cu are mixed to be Ag: Cu = 7: 3 in mass ratio. The AgCu eutectic is a relatively hard crystal, so that the hardness of the joining layer is high. The hard joining layer fails to sufficiently mitigate the stress generated between a ceramic substrate and a copper plate. This is prominent when the TCT is performed under a high-temperature environment.

### RELEVANT REFERENCES

WO 2011/034075 A describes a ceramic-metal circuit board comprising a Si₃N₄ substrate sandwiched between two Cu plates up to 0,8 mm thick, and also aims at improving TCT characteristics. One example of brazing material has the following weight composition Ag:Cu:In:Ti ₌ 60:25:10:5.
US 2012 080216 A1 discloses a brazing material capable of being restrained from protruding unnecessarily in a joint region; a heat dissipation base having a high reliability of electric insulation, and does not easily cause a short circuit even when the base dissipates heat repeatedly; and an electronic device wherein an electronic component is mounted on circuit members of this heat dissipation base. The brazing material comprises silver and copper as main components; at least one element A selected from indium, zinc, and tin; at least one element B selected from titanium, zirconium, hafnium, and niobium; and at least one element C selected from molybdenum, osmium, rhenium, and tungsten.
US 2014 291699 A1 discloses a ceramic/copper circuit board which includes a ceramic substrate and first and second copper plates bonded to surfaces of the ceramic substrate via bonding layers containing active metal elements.
US 2015 257252 A1 provides a semiconductor circuit board in which a conductor portion is provided on an insulating substrate, wherein a surface roughness of a semiconductor element-mounting section of the conductor portion is 0.3 µm or lower. The ceramic-metal circuit board comprises a Si₃N₄ substrate sandwiched between two Cu plates with a Ag:Cu:Ti:(In or Sn) brazing composition. This document also mentions TCT characteristics.
EP 3 358 614 A1 ,which has been published after the priority date of the present application, discloses to improve a TCT characteristic of a circuit substrate. The circuit substrate comprises a ceramic substrate including a first and second surfaces, and first and second metal plates respectively bonded to the first and second surfaces via first and second bonding layers. A three-point bending strength of the ceramic substrate is 500 MPa or more. At least one of L1/H1 of a first protruding portion of the first bonding layer and L2/H2 of a second protruding portion of the second bonding layer is 0.5 or more and 3.0 or less. At least one of an average value of first Vickers hardnesses of 10 places of the first protruding portion and an average value of second Vickers hardnesses of 10 places of the second protruding portion is 250 or less.

### SUMMARY

A joined body according to the invention is described is claim 1. In particular it comprises: a ceramic member; and a copper member joined to the ceramic member with a joining layer therebetween. A nanoindentation hardness H_{IT} of the joining layer is 1.0 GPa or more and 2.5 GPa or less.

### BRIEF DESCRIPTION OF THE DRAWINGS

Fig. 1 is a view illustrating one example of a ceramic-copper joined body.
Fig. 2 is a view illustrating one example of the ceramic-copper joined body.
Fig. 3 is a view illustrating one example of a joint end portion between a ceramic substrate and a copper plate.
Fig. 4 is a view illustrating a loading condition using a nanoindenter.

### DETAILED DESCRIPTION

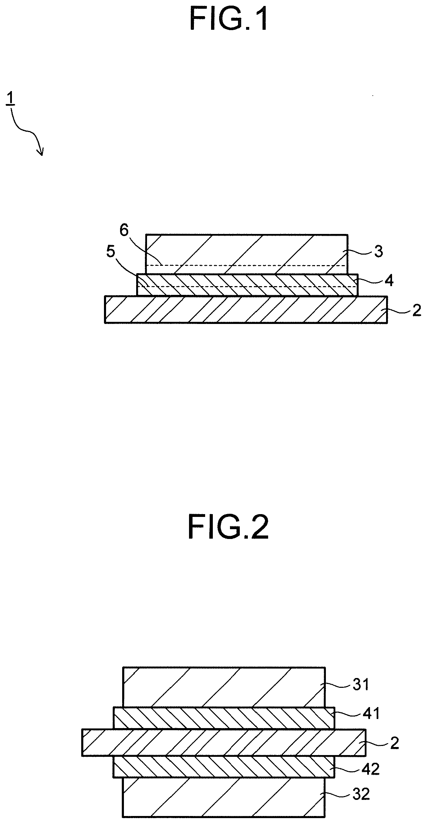

Fig. 1 and Fig. 2 are views each illustrating one example of a ceramic-copper joined body. Fig. 1 and Fig. 2 illustrate a joined body 1, a ceramic substrate 2, a copper 25 plate 3 (a front copper plate 31, a rear copper plate 32), a joining layer 4 (a front surface side joining layer 41, a rear surface side joining layer 42), a center portion 5 of the joining layer 4, and a region 6 positioned at 100 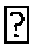 m in the thickness direction of the copper plate 3 from the interface between the copper plate 3 and the joining layer 4.

The joined body 1 illustrated in Fig. 1 includes the copper plate 3 joined to one surface of the ceramic substrate 2. The joined body 1 illustrated in Fig. 2 includes the front copper plate 31 and the rear copper plate 32 joined to both surfaces of the ceramic substrate 2. The front copper plate 31 is joined to one surface of the ceramic substrate 2 with the front surface side joining layer 41 interposed therebetween, and the rear copper plate 32 is joined to the other surface of the ceramic substrate 2 with the rear surface side joining layer 42 interposed therebetween. Fig. 1 and Fig. 2 each illustrate an example that has a single copper plate having the joined body 1 joined to one surface thereof, but the example may have a plurality of copper plates each having the joined body 1 joined to one surface thereof.

The three-point bending strength of the ceramic substrate 2 is preferred to be 500 MPa or more. Using a ceramic substrate with the above-described strength being 500 MPa or more allows to thin the substrate to 0.4 mm or less. Examples of the ceramic substrate whose three-point bending strength is 500 MPa or more include a silicon nitride substrate, a highly strengthened aluminum nitride substrate, an alumina substrate, a zirconia-containing alumina substrate, and so on.

Among these ceramic substrates, the silicon nitride substrate is preferable. The three-point bending strength of ordinary aluminum nitride substrate and alumina substrate is about 300 to 450 MPa. Thinning the substrate whose strength is less than 500 MPa to 0.4 mm or less leads to a decrease in TCT characteristics. Particularly, when the temperature of the high-temperature side of a TCT is as high as 175°C or more, durability decreases.

The silicon nitride substrate can achieve high strength of 500 MPa or more or further 600 MPa or more in terms of the three-point bending strength. The heat conductivity of 50 W/m·K or more or further 80 W/m·K or more can be achieved. In recent years, a silicon nitride substrate having both high strength and high heat conductivity has also become available. A silicon nitride substrate having a three-point bending strength of 500 MPa or more and a heat conductivity of 80 W/m·K or more also enables thinning of the substrate to 0.30 mm or less. The three-point bending strength is measured according to JIS-R-1601, and the heat conductivity is measured according to JIS-R-1611.

The thickness of the copper plate 3 is preferred to be 0.3 mm or more or further 0.7 mm or more. Thickening the copper plate 3 makes it possible to improve a heat dissipation property. It is possible to increase ampacity when the copper plate 3 is used for a circuit board.

Thermal resistance (Rth) can be found by Expression: Rth = H/(k × A). H represents a heat transfer path, k represents a heat conductivity, and A represents a heat dissipated area. In order to reduce the thermal resistance (Rth), shortening the heat transfer path (H), increasing the heat conductivity (k), and increasing the heat dissipated area (A) can be cited. In the joined body according to the embodiment, thinning the ceramic substrate 2 makes it possible to shorten the heat transfer path of a portion with a low heat conductivity. Further, thickening the copper plate 3 makes it possible to increase the heat conductivity (k) and the heat dissipated area (A) of the joined body. As a result, the thermal resistance (Rth) can be reduced.

A nanoindentation hardness H_{IT} of the joining layer 4 falls within a range of 1.0 to 2.5 GPa. The nanoindentation hardness H_{IT} of less than 1.0 GPa causes deficiency of a joining strength because the joining layer 4 is too soft. On the other hand, the large nanoindentation hardness H_{IT} in excess of 2.5 GPa causes deficiency of the TCT characteristics under a high-temperature environment because the joining layer 4 is hard. Therefore, the nanoindentation hardness H_{IT} of the joining layer falls within a range of 1.0 to 2.5 GPa and preferably in a range of 1.1 to 2.1 GPa.

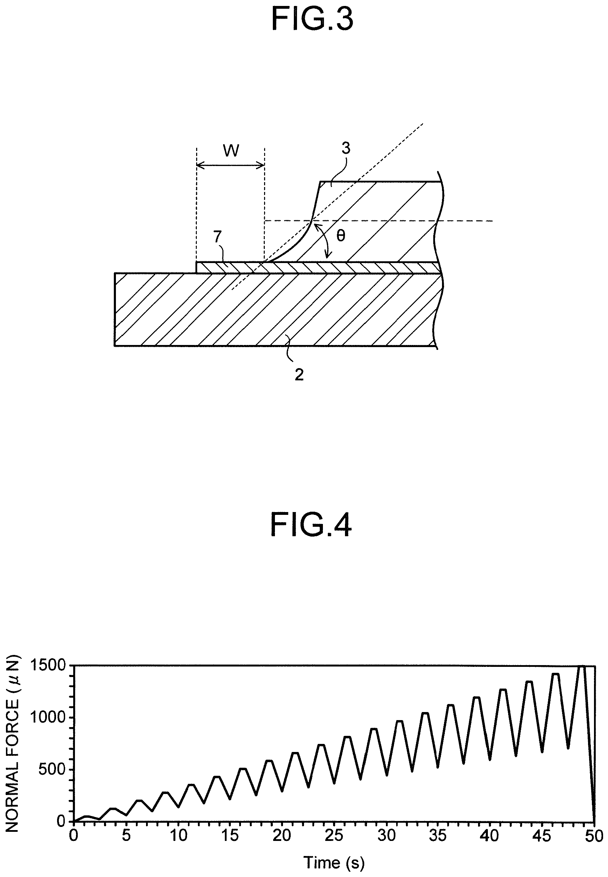

The nanoindentation hardness H_{IT} is measured by using a nanoindenter. In the measurement using the nanoindenter, the hardness can be found by pressing the indenter into a sample surface by micro force and measuring an indentation depth and a pressing force at this time. The indentation of the nanoindenter is as small as about 1 µm. Therefore, it is possible to measure the hardness of a minute region. Using the nanoindenter enables the measurement without removing the copper plate. The nanoindentation hardness H_{IT} is measured by using a nanoindenter manufactured by Hysitron, Inc., for example, and a Berkovich diamond triangular pyramid indenter. The maximum load is 1500 µN (micronewton) and the load is increased gradually for 50 seconds. How the load is applied is as illustrated in Fig. 4. The indentation depth at this time is measured to find the nanoindentation hardness H_{IT}.

The measurement by the nanoindenter is performed on an arbitrary cross section of the joined body. The cross section is polished so as to obtain 5 µm or less of surface roughness Ra. The measurement is performed along the center portion 5 of the joining layer 4. Arbitrary three places along the center portion 5 of the joining layer 4 are measured and the average value of the measurements is set to the nanoindentation hardness H_{IT}.

The joined body according to the embodiment includes a soft joining layer. Therefore, even when the temperature of the high-temperature side of the TCT is 175°C or more, excellent durability is exhibited. Thus, it is possible to obtain excellent reliability when using the above-described joined body for a semiconductor circuit board.

A Vickers hardness H_{V} of the copper plate 3 is preferred to be 100 or less. The Vickers hardness H_{V} of the copper plate 3 more preferably falls within a range of 40 to 80. The Vickers hardness H_{V} is measured according to JIS-R-1610. Using the soft copper plate 3 makes it possible to reduce a heat stress. The copper plate 3 has a recrystallization structure, thereby making it possible to lower the hardness. The copper plate 3 is preferably formed by causing secondary recrystallization to increase the grain diameter. The hardness of the copper plate 3 is found from the length of a diagonal line in two directions of an indentation by applying a load to the surface of the copper plate by an indenter at a load of 50 gf for a load holding time of 10 seconds.

The difference between a nanoindentation hardness H_{IT} of the place 6 that is 100 µm away in the thickness direction of the copper plate 3 from the joint interface between the copper plate 3 and the joining layer 4 in the copper plate 3 and the nanoindentation hardness H_{IT} of the joining layer is 0.5 GPa or less. Fig. 1 illustrates the place 6 that is 100 µm away from the joint interface between the copper plate 3 and the joining layer 4 in the copper plate 3 as an example. The nanoindentation hardness H_{IT} is measured along the place 6. Arbitrary three places are measured by the same method as that described previously using the nanoindenter. The average value of the measurements is set to the nanoindentation hardness H_{IT} of the place 6. The difference between the nanoindentation hardness H_{IT} of the place 6 and the nanoindentation hardness H_{IT} of the joining layer 4 being 0.5 GPa or less indicates that the component of the joining layer 4 is diffused into the copper plate 3. This makes it possible to improve the joining strength, and at the same time, manufacture the joined body resistant to the heat stress.

The boundary between the copper plate 3 and the joining layer 4 is in a copper-rich state, and thus can be distinguished. It is also effective to perform element mapping by an electron probe microanalyzer (EPMA) as necessary. Even when Ag in the joining layer 4 is diffused into the copper plate 3, the boundary between the copper plate 3 and the joining layer 4 can be distinguished because the content of Ag in the copper plate 3 is smaller than that in the joining layer 4.

The joining layer 4 contains an Ag-Ti compound. The joining layer 4 preferably contains TiC. The presence of the Ag-Ti compound or TiC makes it possible to control the nanoindentation hardness H_{IT} of the joining layer 4. The presence or absence of Ag-Ti crystal or TiC can be measured by the presence or absence of a peak by an X-ray diffraction (XRD) analysis.

In order to control the nanoindentation hardness H_{IT} of the joining layer 4, it is preferred to control a joining brazing material. As the joining brazing material, a brazing material containing Ag (silver), Cu (copper), and Ti (titanium) is used. The joining layer 4 contains at least one element selected from In (indium) and Sn (tin), and optionally C (carbon).

In the case (not claimed) of the brazing material composed of Ag, Cu, and Ti, preferably, Ag falls within a range of 40 to 80 mass%, Cu falls within a range of 15 to 45 mass%, Ti falls within a range of 1 to 12 mass%, and Ag + Cu + Ti = 100 mass% is established. In the case of adding In, Sn, i.e. according to the invention, the added amount of at least one element selected from In and Sn is 5 to 20 mass%. In the case of adding C, its added amount preferably falls within a range of 0.1 to 2 mass%. In the case of the brazing material being composed of five types of Ag, Cu, Ti, Sn (or In), and C, preferably, Ag is adjusted to a range of 40 to 80 mass%, Cu is adjusted to a range of 15 to 45 mass%, Ti is adjusted to a range of 1 to 12 mass%, Sn (or In) is adjusted to a range of 5 to 20 mass%, C is adjusted to a range of 0.1 to 2 mass%, and Ag + Cu + Ti + Sn ( or In) + C = 100 mass% is established.

In order to control the nanoindentation hardness H_{IT} of the joining layer 4 to a range of 1.0 to 2.5 GPa, a mass ratio Ag/Cu of Ag to Cu is set to 2.1 or less. The mass ratio Ag/Cu is preferably set to 1.2 or more and 1.7 or less. Controlling the mass ratio Ag/Cu to this range facilitates controlling the nanoindentation hardness H_{IT} to a range of 1.0 to 2.5 GPa or further a range of 1.1 to 2.1 GPa.

The Ag-Cu-Ti brazing material utilizes an Ag-Cu eutectic for joining. The Ag-Cu eutectic is composed of 72 mass% of Ag and 28 mass% of Cu. Therefore, the mass ratio Ag/Cu becomes 2.57. The mass ratio Ag/Cu of an ordinary Ag-Cu-Ti brazing material becomes 2.57 or so. On the other hand, the Ag-Cu eutectic is a hard crystal. When the Ag-Cu eutectic crystal increases, the joining layer hardens. Therefore, the hardness of the joining layer also increases. Unless the Ag-Cu eutectic crystal is formed uniformly, the variation in Vickers hardness also increases.

When the proportion of the Ag-Cu eutectic crystal decreases, the joining layer 4 becomes soft. Even if it becomes too soft, the TCT characteristics decrease. Therefore, it is preferred to control Ag/Cu. In the case of having a stacked structure of a copper plate/a joining layer/a ceramic substrate, destruction by the heat stress starts from a weak portion. Using the ceramic substrate whose three-point bending strength is 500 MPa or more makes it possible to prevent occurrence of cracking in the ceramic substrate. When the strength of the ceramic substrate is low, cracking becomes likely to occur in the ceramic substrate by the heat stress. Therefore, using a high-strength ceramic substrate whose three-point bending strength is 500 MPa or more is an effective technique.

Even though the high-strength ceramic substrate is used, there occurs a phenomenon in which cracking occurs in the joining layer itself by the heat stress. Reducing the nanoindentation hardness of the joining layer makes it possible to mitigate the heat stress in the joining layer. However, even if the joining layer is too soft, cracking becomes likely to occur in the joining layer by the heat stress.

In order to make the nanoindentation hardness H_{IT} of the joining layer fall within a range of 1.0 to 2.5 GPa, it is effective to combine with one or two or more of control of the Ag/Cu mass ratio, generation of the Ag-Ti crystal, and generation of the TiC crystal.

It is also effective to make the thickness of the joining layer after joining fall within a range of 5 µm or more and 35 µm or less. A joining layer that is as thin as less than 5 µm may lack the function to mitigate the heat stress. The joining strength may decrease. On the other hand, a joining layer having a thickness in excess of 35 µm causes an increase in cost. Therefore, the thickness of the joining layer is preferably 15 to 25 µm. Incidentally, the thickness of the joining layer also includes the thickness of a TiN layer formed in a heat joining process.

The mass ratio of Ag/Cu is set to 2.1 or less, thereby making it possible to increase the Cu content relative to the eutectic composition. Increasing the Cu content makes it possible to reduce the hardness of the joining layer. It is also effective for the brazing material to contain at least one element selected from In, Sn, and C. In or Sn enables joining at low temperature (lowering of the melting point of the brazing material), and enables reduction of a residual stress of the joined body. The reduction in residual stress is effective for improving thermal cycle reliability of the joined body. When the content of one or both of In and Sn is less than 5 mass%, it is impossible to sufficiently obtain the effect by addition. On the other hand, when the content exceeds 20 mass%, the joining layer may be too hard.

C is effective in reducing the variation in hardness of the joining layer. C (carbon) enables control of fluidity of the brazing material. Adding 0.1 to 2 mass% of C enables suppression of the fluidity. Therefore, it is possible to reduce the variation in hardness of the joining layer. When the added amount of C is less than 0.1 mass%, the effect by addition is insufficient. On the other hand, when the added amount of C is large in excess of 2 mass%, the joining layer may become too hard.

Ti preferably falls within a range of 5 to 11 mass%. Ti reacts with nitrogen of the silicon nitride substrate to form a TiN (titanium nitride) phase. The formation of the TiN phase enables improvement in the joining strength. The joining strength (peel strength) of a metal plate can be made as high as 17 kN/m or more or further 20 kN/m or more. With the mass ratio of Ag/Cu set to 2.1 or less, the content of Ti is set to 5 mass% or more. By the increase in the content of Cu, the content of the Ag-Cu eutectic crystal decreases, thereby making it possible to suppress that a brazing material protruding portion becomes too hard, leading to insufficiency of the effect of mitigating the heat stress. On the other hand, increasing the Ti content facilitates formation of the Ag-Ti crystal and the TiC crystal when heating the brazing material. The Ag-Ti crystal and the TiC crystal are formed as a result of reaction of Ti that did not become TiN (titanium nitride) with Ag (silver) or C (carbon). Due to being formed by the reaction, they can be minute crystalline compounds.

The presence or absence of the Ag-Ti crystal or the TiC crystal in the joining layer 4 can be confirmed by XRD. A polished surface obtained by polishing the cross section of the joining layer so as to obtain 1 µm or less of surface roughness is measured. The XRD analysis is performed under measurement conditions of a Cu target (Cu-α), a tube voltage of 40 kV, a tube current of 40 mA, a scanning speed of 2.0 degree/min, a slit (RS) of 0.15 mm, and a scanning zone (2θ) of 1 0 degrees to 60 degrees.

The peak of Ag (I_{Ag}) and the peak of AgTi (I_{AgTi}) are preferably detected in a range of 37.5 degrees to 38.5 degrees. A peak ratio of I_{AgTi} to I_{Ag} (I_{AgTi}/I_{Ag}) preferably falls within a range of 0.5 or more and 1.2 or less. The XRD peak ratio indicates the existing ratio of an AgTi crystal to an Ag crystal in the joining layer. The XRD peak ratio being in a predetermined peak ratio range indicates that the AgTi crystal exists.

In a joining process, a paste of the above-described joining brazing material is prepared, the joining brazing material paste is applied on a ceramic member, and the copper plate 3 is arranged thereon. The application thickness of the joining brazing material paste preferably falls within a range of 10 to 40 µm. An application thickness of less than 10 µm may cause a decrease in the joining strength because the joining brazing material becomes short. A thick application thickness in excess of 40 µm fails to improve the joining strength, and further causes an increase in cost. When the copper plate 3 is joined to both surfaces, the joining brazing material paste is applied on both surfaces of the ceramic member.

Next, heat joining is performed. A heating temperature is in a range of 700 to 900°C. The heat joining is performed under the pressure of 1 × 10⁻³ Pa or less in a non-oxidizing atmosphere. In the heat joining process, holding is preferably performed for 30 minutes or more at the heating temperature in a range of 700 to 900°C. By providing the holding time, Ag in the brazing material is diffused into the copper plate 3. This makes it easier to control the difference between the nanoindentation hardness H_{IT} of the place 6 and the nanoindentation hardness H_{IT} of the joining layer 4 to 0.5 GPa or less.

After the heating process, rapid cooling is preferably performed at a cooling rate of 5°C/minute or more. A rapid cooling process is preferably performed until a freezing-point temperature of the joining layer 4. Performing the rapid cooling process makes it possible to solidify the joining layer 4 early. The brazing material melted by the heating process solidifies early, leading to formation of the joining layer, thereby making it possible to reduce the variation in the nanoindentation hardness H_{IT}.

Next, an etching process is performed as necessary. By the etching process, patterning of the copper plate 3 is performed. When the joined body is used as a semiconductor circuit board, in particular, the copper plate 3 is worked into a pattern shape. By using the etching, an inclined structure is preferably provided on a side surface of the copper plate. There is illustrated one example of a joint end portion between the ceramic substrate and the copper plate in Fig. 3. Fig. 3 illustrates the ceramic substrate 2, the copper plate 3, a joining layer protruding portion 7, a length W of the joining layer protruding portion 7, and a contact angle θ between the side surface of the copper plate 3 and the joining layer protruding portion 7.

The inclined structure is provided on the side surface of the copper plate and the joining layer protruding portion is provided, thereby making it possible to mitigate stresses of the copper plate and the ceramic substrate. This makes it possible to further improve the TCT characteristics.

The joining layer protruding portion 7 is that the joining layer protrudes from the side surface of the copper plate. The length W of the joining layer protruding portion 7 is preferably 10 to 150 µm. The length W of the joining layer protruding portion 7/the thickness of the joining layer protruding portion 7 preferably falls within a range of 0.5 to 3.0. The length W of the joining layer protruding portion 7/the thickness of the joining layer protruding portion 7 more preferably falls within a range of 1.0 to 2.0.

Controlling the length and the thickness of the joining layer protruding portion 7 makes it possible to uniformize directionality of the heat stress (shrinkage and expansion). This makes it possible to suppress occurrence of cracking in the ceramic substrate and the joining layer.

An inclination angle θ of the side surface of the copper plate is an angle of the side surface when the cross section of the copper plate 3 is observed. The angle θ preferably falls within a range of 40 to 84 degrees. Providing the inclined structure further improves the effect of mitigating the heat stress. The side surface of the copper plate 3 in contact with the joining layer protruding portion 7 is preferably inclined. The angle of an upper end portion of the copper plate 3 (angle between the upper surface and the side surface of the copper plate 3) is preferred to be substantially vertical, which is 85 to 95 degrees. Such a structure is effective when the thickness of a metal plate is 0.6 mm or more or further 0.8 mm or more in particular. By setting the inclination angle θ of the side surface of the copper plate in contact with the joining layer protruding portion to 40 to 84 degrees and setting the angle of the upper end portion of the copper plate to 85 to 95 degrees, a flat surface of the copper plate can be increased after obtaining the effect of mitigating the stress. When the flat surface of the copper plate is increased, it is possible to broaden a mountable area for a semiconductor element. When the mountable area for a semiconductor element can be broadened, it is possible to increase flexibility of circuit design. In order to achieve this, as illustrated in Fig. 3, the contact angle with the joining layer protruding portion preferably falls within a range of 40 to 84 degrees when the copper plate is halved in the thickness direction.

The nanoindentation hardness H_{IT} of the joining layer is controlled as above, and thereby excellent durability is exhibited even when the temperature of the high-temperature side of the TCT increases as high as 175°C or more. The inclined shape of the side surface of the copper plate and the joining layer protruding portion are provided, thereby making it possible to further improve the TCT characteristics.

Therefore, excellent reliability can be obtained when the joined body is used for a semiconductor circuit board. In other words, the joined body according to the embodiment is suitable for a semiconductor circuit board. A semiconductor device is fabricated by mounting a semiconductor element on at least the single copper plate 3 of a semiconductor circuit board.

A semiconductor circuit board according to the embodiment exhibits excellent durability even when the temperature of the high-temperature side of the TCT is 175°C or more. Therefore, it is possible to obtain excellent reliability even when a semiconductor element whose operation guaranteed temperature is 170°C or more is mounted.

### EXAMPLES

### (Examples 1 to 6, Comparative example 1)

As the ceramic substrate, silicon nitride substrates illustrated in Table 1 were prepared.

**[Table 1]**

| Material | Substrate Size (length (mm) × width (mm) × thickness (mm)) | Three-Point Bending Strength (MPa) | Heat Conductivity (W/m·K) |
|---|---|---|---|
| Silicon Nitride Substrate 1 | 50×40×0.32 | 600 | 90 |
| Silicon Nitride Substrate 2 | 50×40×0.25 | 700 | 90 |

As the joining brazing material, brazing materials illustrated in Table 2 were prepared.

**[Table 2]**

| | Brazing Material Component (mass%) | Mass Ratio (Ag/Cu) |
|---|---|---|
| | Total of Metal Components is Set to 100 mass% | |
| Brazing Material 1 | Ag(75), Cu(24), Ti(1) | 3.1 |
| Brazing Material 2 | Ag(59), Cu(26), In(10), Ti(5) | 2.3 |
| Brazing Material 3 | Ag(50), Cu(25), Sn(11), In(6), Ti(7), C(1) | 2.0 |
| Brazing Material 4 | Ag(48), Cu(36.5), Sn(7), Ti(8), C(0.5) | 1.3 |

A paste of the joining brazing material was applied on the silicon nitride substrate, and a copper plate was arranged thereon. The application thickness of the joining brazing material paste was set to be within a range of 20 to 30 µm.

Next, as the joining process, the copper plate was joined to the silicon nitride substrate at 780 850°C, in a non-oxidizing atmosphere, and at 1 × 10⁻³ Pa or less. In the joining process, holding was performed for 30 minutes or more in the above-described temperature range. In the examples, the cooling rate after the heat joining was set to 5°C/minute or more. In the comparative example, the cooling rate was set to 2°C/minute or less.

Next, the etching process was performed, a front copper plate was worked into a pattern shape. As the front copper plate, two copper plates each having a size of 20 mm in length × 30 mm in width × 0.8 mm in thickness were prepared, and the distance between the copper plates was set to 1.2 mm. As a rear copper plate, a single copper plate having a size of 40 mm in length × 32 mm in width × 0.8 mm in thickness was prepared.

By the etching, the side surface shape of the copper plate and the length of a joining layer protruding portion were adjusted. Results thereof are illustrated in Table 3. In this manner, ceramic-copper joined bodies according to the examples and the comparative example were fabricated. The Vickers hardness H_{V} of each of the copper plates was within a range of 40 to 80.

**[Table 3]**

| | Ceramic Substrate | Brazing Material | θ (degree) | Angle of Upper End Portion of Copper Plate (degree) | W (µm) |
|---|---|---|---|---|---|
| Example 1 | Silicon Nitride Substrate 1 | Brazing Material 2 | 40 | 90 | 40 |
| Example 2 | Silicon Nitride Substrate 1 | Brazing Material 3 | 50 | 90 | 30 |
| Example 3 | Silicon Nitride Substrate 1 | Brazing Material 4 | 60 | 90 | 20 |
| Example 4 | Silicon Nitride Substrate 2 | Brazing Material 2 | 45 | 90 | 40 |
| Example 5 | Silicon Nitride Substrate 2 | Brazing Material 3 | 55 | 90 | 30 |
| Example 6 | Silicon Nitride Substrate 2 | Brazing Material 4 | 65 | 90 | 20 |
| Comparative Example 1 | Silicon Nitride Substrate 1 | Brazing Material 1 | 40 | 90 | 100 |

Joining layers of ceramic circuit boards according to the examples and the comparative example were within a range of 15 to 25 µm. Ag in the joining brazing material was confirmed to be diffused into a copper member. The nanoindentation hardness H_{IT} of the joining layer was measured on each of the ceramic circuit boards according to the examples and the comparative example. Each of the joined bodies was cut and a cut surface was polished so as to obtain 5 µm or less of surface roughness Ra. Three places along the center line of the joining layer were chosen arbitrarily to be measured. The average value of the measurements was calculated. The nanoindentation hardness H_{IT} of the joining layer was represented as H_{IT}(A).

The nanoindentation hardness H_{IT} of a place that is 100 µm away in the thickness direction of the copper plate from the joint interface between the copper plate and the joining layer in the copper plate was also measured. Three places that were each 100 µm away in the thickness direction of the copper plate from the interface between the joining layer and the copper plate in the copper plate were arbitrarily chosen to be measured. The average value of the measurements and the difference between nanoindentation hardness H_{IT} of the place and the previously-described nanoindentation hardness H_{IT} of the joining layer were illustrated. The nanoindentation hardness H_{IT} of the place that is 100 µm away in the thickness direction of the copper plate from the joint interface between the copper plate and the joining layer in the copper plate is represented as H_{IT}(B).

As a nanoindenter, a "TI 1950 TriboIndenter" manufactured by Hysitron, Inc. was used. As an indenter, a Berkovich diamond triangular pyramid indenter was used. The loading condition was set to 1500 µN (micronewton) as the maximum load, and a method in which the load was gradually increased for 50 seconds as illustrated in Fig. 4 was employed. In Fig. 4, the horizontal axis indicates a second (s) and the vertical axis indicates a load (µN). An indentation depth at this time was measured to find the nanoindentation hardness H_{IT}.

The presence or absence of Ag-Ti compound crystal or TiC crystal in the joining layer was measured. The peak ratio (I_{AgTi}/I_{Ag}) was also examined. These were examined according to the presence or absence of a peak by the XRD analysis. The XRD analysis was performed under measurement conditions of a Cu target (Cu-α), a tube voltage of 40 kV, a tube current of 40 mA, a scanning speed of 2.0 degree/min, a slit (RS) of 0.15 mm, and a scanning zone (2θ) of 10 to 60 degrees. The peak ratio (I_{AgTi}/I_{Ag}) was found by setting the maximum peak of the Ag crystal to I_{Ag} and setting the maximum peak of the AgTi crystal to I_{AgTi} in a range of 37.5 to 38.5 degrees. Results thereof are illustrated in Table 4.

**[Table 4]**

| | H_{IT}(A) (GPa) | H_{IT}(B) (GPa) | Hₙ(A)-H_{IT}(B) (OPa) | Presence or Absence of Ag-Ti Compound Crystal in Joining Layer | I _{AgTi}/ I _{Ag} | Presence or Absence of Tic Crystal in Joining Layer |
|---|---|---|---|---|---|---|
| Example 1 | 2 | 1.5 | 0.5 | Presence | 0.5 | Absence |
| Example 2 | 1.5 | 1.2 | 0.3 | Presence | 0.7 | Presence |
| Example 3 | 1.2 | 1 | 0.2 | Presence | 0.9 | Presence |
| Example 4 | 2 | 1.5 | 0.5 | Presence | 0.5 | Absence |
| Example 5 | 1.5 | 1.2 | 0.3 | Presence | 0.7 | Presence |
| Example 6 | 1.2 | 1 | 0.2 | Presence | 0.9 | Presence |
| Comparative Example 1 | 3.2 | 2.3 | 0.9 | Absence | - | Absence |

As is clear from the table, in each of the ceramic-copper joined bodies according to the examples, the nanoindentation hardness H_{IT}(A) was within a range of 1.0 to 2.5 GPa. The difference between the nanoindentation hardness H_{IT}(A) and the nanoindentation hardness H_{IT}(B ) of the place that was 100 µm away in the thickness direction of the copper plate from the joint interface between the copper plate and the joining layer in the copper plate was 0.5 GPa or less. The Ag-Ti compound crystal was confirmed in the joining layer. The TiC crystal was confirmed in the brazing material made by adding C to the joining brazing material. In contrast to this, in the comparative example, these were each out of a preferable range.

Next, the joining strength of the copper plate of each of the ceramic-copper joined bodies according to the examples and the comparative example was measured and each of the ceramic-copper joined bodies were subjected to the TCT. The joining strength of the copper plate was found as a peel strength. Concretely, a metal terminal having a 1 -mm width was joined to a metal circuit board and pulled in the vertical direction to measure the peel strength.

The TCT was performed under two types of conditions. In a test 1, -40°C × holding for 30 minutes → room temperature × holding for 10 minutes → 175°C × holding for 30 minutes → room temperature × holding for 10 minutes was set as one cycle and the presence or absence of failure of the ceramic metal circuit board after 3000 cycles was measured. In a test 2, -40°C × holding for 30 minutes → room temperature × holding for 10 minutes → 250°C × holding for 30 minutes → room temperature × holding for 10 minutes was set as one cycle and the presence or absence of failure of the ceramic metal circuit board after 3000 cycles was measured. The presence or absence of failure of the ceramic metal circuit board was confirmed by finding the occurrence area of cracking between the ceramic substrate and the metal plate by a scanning acoustic tomograph (STA). The occurrence area of cracking was evaluated as an index η. The case of η being 100% was described as "no cracking" and the case of η being 0% was described as "cracking occurred extensively." Results thereof are illustrated in Table 5.

**[Table 5]**

| | Peel Strength (kN/m) | η(%) | |
|---|---|---|---|
| | | Test 1 | Test 2 |
| Example 1 | 23 | 100 | 97 |
| Example 2 | 27 | 100 | 100 |
| Example 3 | 29 | 100 | 100 |
| Example 4 | 23 | 100 | 97 |
| Example 5 | 27 | 100 | 100 |
| Example 6 | 29 | 100 | 100 |
| Comparative Example 1 | 20 | 30 | 15 |

As is clear from the table, each of the ceramic-copper joined bodies according to the examples was also excellent in peel strength and TCT characteristics. In contrast to this, they became inferior in the comparative example. The result of the TCT, in particular, was inferior. It was found out that it was impossible to sufficiently mitigate the heat stress under a high-temperature condition of 170°C or more when the copper plate was as thick as 0.6 mm or more. These results reveal that the ceramic-copper joined bodies according to the examples are each excellent in TCT characteristics under a high-temperature environment. Therefore, the ceramic-copper joined bodies according to the examples are each suitable for a semiconductor circuit board intended for mounting a semiconductor element whose operation guaranteed temperature is 170°C or more thereon.

While certain embodiments have been described, these embodiments have been presented by way of example only, and are not intended to limit the invention. Indeed, the embodiments described herein may be embodied in a variety of other forms; furthermore, various omissions, substitutions and changes in the form of the embodiments described herein may be made within the scope of the claims.

## Claims

1. A joined body comprising:
a ceramic member (2); and
a copper plate (31, 32) having a thickness of 0.3 mm or more joined to the ceramic member (2) with a joining layer (41, 42) therebetween, wherein:
the joining layer (41, 42) includes a brazing material,
the brazing material contains Ag, Cu, Ti and at least one element selected from the group consisting of Sn and In , a mass ratio of Ag to Cu in the joining layer (41, 42) is 2.1 or less,
a content of Ti in the joining layer (41, 42) is 5 mass% or more,
a content of at least one element selected from Sn and In in the joining layer (41, 42) is 5 mass % or more and 20 mass % or less,
the joining layer (41, 42) contains an Ag-Ti crystal,
the joining layer (41, 42) gives an X-ray diffraction pattern having an intensity ratio (I_{AgTi}/I_{Ag}) of a maximum peak ascribed to the Ag-Ti crystal (I_{AgTi}) to a maximum peak ascribed to an Ag crystal (I_{Ag}) of 0.5 or more and 1.2 or less within a range of 37.5 degrees to 38.5 degrees of the X-ray diffraction pattern, and
a nanoindentation hardness H_{IT} of the joining layer (41, 42) is 1.0 GPa or more and 2.5 GPa or less, the nanoindentation hardness H_{IT} of the joining layer (41, 42) being defined by an average value of three nanoindentation hardnesses measured respectively at three different places along a center portion of a cross section of the joining layer, the three nanoindentation hardnesses of the joining layer (41, 42) being measured by a nanoindenter, as disclosed in the description and Figure 4,
the copper plate (31, 32) has a region being 100 µm away in a thickness direction of the copper plate (31, 32) from the interface between the copper plate (31, 32) and the joining layer (41, 42), and
the difference between the nanoindentation hardness H_{IT} of the joining layer (41, 42) and a nanoindentation hardness H_{IT} of the region is 0.5 GPa or less, the nanoindentation hardness H_{IT} of the region being defined by an average value of three nanoindentation hardnesses measured respectively at three different places of a cross section of the region, the three nanoindentation hardnesses of the region being measured by a nanoindenter, as disclosed in the description and Figure 4

2. The joined body according to claim 1, wherein the ceramic member (2) is a silicon nitride substrate having a thickness of 0.4 mm or less.

3. The joined body according to claim 1, wherein the copper plate (31, 32) has a thickness of 0.7 mm or more.

4. The joined body according to claim 1, wherein the copper plate (31, 32) has a Vickers hardness Hᵥ of 100 or less, when measured according to JIS-R-1610.

5. The joined body according to claim 1, wherein the ceramic member (2) has a three-point bending strength of 500 MPa or more when measured according to JIS-R-1601.

6. The joined body according to claim 1, wherein the joining layer (41, 42) further contains a TiC crystal.

7. The joined body according to claim 1, wherein: the brazing material further contains C.

8. The joined body according to claim 1, further comprising a plurality of the copper plates (31, 32).

9. A circuit board comprising the joined body according to claim 1.

10. A semiconductor device comprising:
the circuit board according to claim 9; and
a semiconductor element on the copper plate (31, 32).

11. A method of manufacturing a joined body, the method comprising the steps of:
applying a brazing material on a ceramic member (2) and disposing a copper plate (31, 32) having a thickness of 0.3 mm or more on the brazing material, the brazing material containing Ag, Cu, Ti and at least one element selected from the group consisting of Sn and In , a mass ratio of Ag to Cu in the brazing material being 2.1 or less, a content of Ti in the brazing material being 5 mass% or more, and a content of at least one element selected from Sn and In in the brazing material being 5 mass % or more and 20 mass % or less; and
performing heat-bonding of the ceramic member (2) and the copper plate (31, 32) with the brazing material at a temperature of 700°C or more and 900°C or less for 30 minutes or more, a pressure of 1 × 10⁻³Pa or less, and under a non-oxidizing atmosphere, so as to form a joining layer (41, 42) bonding the ceramic member (2) and the copper plate (31, 32), wherein:
the joining layer (41, 42) contains an Ag-Ti crystal,
the joining layer (41, 42) gives an X-ray diffraction pattern having an intensity ratio (I_{AgTi}/I_{Ag}) of a maximum peak ascribed to the Ag-Ti crystal (I_{AgTi}) to a maximum peak ascribed to an Ag crystal (I_{Ag}) of 0.5 or more and 1.2 or less within a range of 37.5 degrees to 38.5 degrees of the X-ray diffraction pattern, and
a nanoindentation hardness HIT of the joining layer (41, 42) is 1.0 GPa or more and 2.5 GPa or less, the nanoindentation hardness H_{IT} of the joining layer (41, 42) being defined by an average value of three nanoindentation hardnesses measured respectively at three different places along a center portion of a cross section of the joining layer, the three nanoindentation hardnesses of the joining layer (41, 42) being measured by a nanoindenter, as disclosed in the description and Figure 4,
the copper plate (31, 32) has a region being 100 µm away in a thickness direction of the copper plate (31, 32) from the interface between the copper plate (31, 32) and the joining layer (41, 42), and
the difference between the nanoindentation hardness H_{IT} of the joining layer (41, 42) and a nanoindentation hardness H_{IT} of the region is 0.5 GPa or less, the nanoindentation hardness H_{IT} of the region being defined by an average value of three nanoindentation hardnesses measured respectively at three different places of a cross section of the region, the three nanoindentation hardnesses of the region being measured by a nanoindenter, as disclosed in the description and Figure 4.

12. The method according to claim 11, wherein the brazing material further contains C.

13. The method according to claim 11, wherein a mass ratio of Ag to Cu in the brazing material is 1.2 or more and 1.7 or less.

14. The method according to claim 11, wherein the applied brazing material has a thickness of 10 µm or more and 40 µm or less.

15. The method according to claim 11, wherein the ceramic member (2) has a three-point bending strength of 500 MPa or more, when measured according to JIS-R-1601.

## Patentansprüche

1. Ein zusammengesetzter Körper, umfassend:
ein Keramikelement (2); und
eine Kupferplatte (31, 32) mit einer Dicke von 0,3 mm oder mehr, die mit dem Keramikelement (2) mit einer Verbindungsschicht (41, 42) dazwischen zusammengesetzt ist, wobei:
die Verbindungsschicht (41, 42) ein Lötmaterial umfasst,
das Lötmaterial Ag, Cu, Ti und mindestens ein Element enthält, das aus der Gruppe ausgewählt ist, die aus Sn und In besteht,
ein Massenverhältnis von Ag zu Cu in der Verbindungsschicht (41, 42) 2,1 oder weniger beträgt,
ein Gehalt an Ti in der Verbindungsschicht (41, 42) 5 Massenprozent oder mehr beträgt,
ein Gehalt an mindestens einem Element, ausgewählt aus Sn und In, in der Verbindungsschicht (41, 42) 5 Massen-% oder mehr und 20 Massen-% oder weniger beträgt,
die Verbindungsschicht (41, 42) einen Ag-Ti-Kristall enthält,
die Verbindungsschicht (41, 42) ein
Röntgenbeugungsmuster mit einem Intensitätsverhältnis (I_{AgTi}/I_{Ag}) eines maximalen Peaks, der dem Ag-Ti-Kristall (I_{AgTi}) zugeschrieben wird, zu einem maximalen Peak, der einem Ag-Kristall (I_{Ag}) zugeschrieben wird, von 0,5 oder mehr und 1,2 oder weniger innerhalb eines Bereichs von 37,5 Grad bis 38,5 Grad des Röntgenbeugungsmusters ergibt, und
eine Nanoindentationshärte HIT der Verbindungsschicht (41, 42) 1,0 GPa oder mehr und 2,5 GPa oder weniger beträgt, wobei die Nanoindentationshärte HIT der Verbindungsschicht (41, 42) durch einen Durchschnittswert von drei Nanoindentationshärten definiert ist, die jeweils an drei verschiedenen Stellen entlang eines zentralen Abschnitts eines Querschnitts der Verbindungsschicht gemessen wurden, wobei die drei Nanoindentationshärten der Verbindungsschicht (41, 42) mit einem Nanoindenter gemessen wurden, wie in der Beschreibung und Figur 4 offenbart,
die Kupferplatte (31, 32) einen Bereich aufweist, der in einer Dickenrichtung der Kupferplatte (31, 32) 100 pm von der Grenzfläche zwischen der Kupferplatte (31, 32) und der Verbindungsschicht (41, 42) entfernt ist, und
die Differenz zwischen der Nanoindentationshärte HIT der Verbindungsschicht (41, 42) und einer Nanoindentationshärte HIT des Bereichs 0,5 GPa oder weniger beträgt, wobei die Nanoindentationshärte HIT des Bereichs durch einen Durchschnittswert von drei Nanoindentationshärten definiert ist, die jeweils an drei verschiedenen Stellen eines Querschnitts des Bereichs gemessen wurden, wobei die drei Nanoindentationshärten des Bereichs mit einem Nanoindenter gemessen wurden, wie in der Beschreibung und Figur 4 offenbart.

2. Der zusammengesetzte Körper gemäß Anspruch 1, wobei das Keramikelement (2) ein Siliziumnitrid-Substrat mit einer Dicke von 0,4 mm oder weniger ist.

3. Der zusammengesetzte Körper gemäß Anspruch 1, wobei die Kupferplatte (31, 32) eine Dicke von 0,7 mm oder mehr aufweist.

4. Der zusammengesetzte Körper gemäß Anspruch 1, wobei die Kupferplatte (31, 32) eine Vickers-Härte _{Hv} von 100 oder weniger aufweist, wenn sie in Übereinstimmung mit JIS-R-1610 gemessen wird.

5. Der zusammengesetzte Körper gemäß Anspruch 1, wobei das Keramikelement (2) eine Dreipunkt-Biegefestigkeit von 500 MPa oder mehr aufweist, wenn es in Übereinstimmung mit JIS-R-1601 gemessen wird.

6. Der zusammengesetzte Körper gemäß Anspruch 1, wobei die Verbindungsschicht (41, 42) ferner einen TiC-Kristall enthält.

7. Der zusammengesetzte Körper gemäß Anspruch 1, wobei: das Lötmaterial weiterhin C enthält.

8. Der zusammengesetzte Körper gemäß Anspruch 1 umfasst ferner eine Mehrzahl der Kupferplatten (31, 32).

9. Eine Leiterplatte, die den zusammengesetzten Körper gemäß Anspruch 1 umfasst.

10. Eine Halbleiter Vorrichtung umfassend:
die Leiterplatte gemäß Anspruch 9; und
ein Halbleiterelement auf der Kupferplatte (31, 32).

11. Verfahren zur Herstellung eines zusammengesetzten Körpers, wobei das Verfahren die folgenden Schritte umfasst
Aufbringen eines Lötmaterials auf ein Keramikelement (2) und Anordnen einer Kupferplatte (31, 32) mit einer Dicke von 0,3 mm oder mehr auf dem Lötmaterial, wobei das Lötmaterial Ag, Cu, Ti und mindestens ein Element enthält, das aus der Gruppe ausgewählt ist, die aus Sn und In besteht, wobei ein Massenverhältnis von Ag zu Cu in dem Lötmaterial 2. 1 oder weniger ist, ein Gehalt an Ti in dem Lötmaterial 5 Massen-% oder mehr ist und ein Gehalt an mindestens einem Element, ausgewählt aus Sn und In, in dem Lötmaterial 5 Massen-% oder mehr und 20 Massen-% oder weniger ist; und
Erwärmen des Keramikelements (2) und der Kupferplatte (31, 32) mit dem Lötmaterial bei einer Temperatur von 700°C oder mehr und 900°C oder weniger für 30 Minuten oder mehr, einem Druck von 1 × ¹⁰⁻³Pa oder weniger und unter einer nicht oxidierenden Atmosphäre, um eine Verbindungsschicht (41, 42) zu bilden, die das Keramikelement (2) und die Kupferplatte (31, 32) zusammenfügt, wobei:
die Verbindungsschicht (41, 42) einen Ag-Ti-Kristall enthält,
die Verbindungsschicht (41, 42) ein
Röntgenbeugungsmuster mit einem Intensitätsverhältnis (I_{AgTi}/I_{Ag}) eines maximalen Peaks, der dem Ag-Ti-Kristall (I_{AgTi}) zugeschrieben wird, zu einem maximalen Peak, der einem Ag-Kristall (I_{Ag}) zugeschrieben wird, von 0,5 oder mehr und 1,2 oder weniger innerhalb eines Bereichs von 37,5 Grad bis 38,5 Grad des Röntgenbeugungsmusters ergibt, und
eine Nanoindentationshärte HIT der Verbindungsschicht (41, 42) 1,0 GPa oder mehr und 2,5 GPa oder weniger beträgt, wobei die Nanoindentationshärte HIT der Verbindungsschicht (41, 42) durch einen Durchschnittswert von drei Nanoindentationshärten definiert ist, die jeweils an drei verschiedenen Stellen entlang eines zentralen Abschnitts eines Querschnitts der Verbindungsschicht gemessen wurden, wobei die drei Nanoindentationshärten der Verbindungsschicht (41, 42) mit einem Nanoindenter gemessen wurden, wie in der Beschreibung und Figur 4 offenbart,
die Kupferplatte (31, 32) einen Bereich aufweist, der in einer Dickenrichtung der Kupferplatte (31, 32) 100 µm von der Grenzfläche zwischen der Kupferplatte (31, 32) und der Verbindungsschicht (41, 42) entfernt ist, und
die Differenz zwischen der Nanoindentationshärte _{HIT} der Verbindungsschicht (41, 42) und einer Nanoindentationshärte _{HIT} des Bereichs 0,5 GPa oder weniger beträgt, wobei die Nanoindentationshärte _{HIT} des Bereichs durch einen Durchschnittswert von drei Nanoindentationshärten definiert ist, die jeweils an drei verschiedenen Stellen eines Querschnitts des Bereichs gemessen wurden, wobei die drei Nanoindentationshärten des Bereichs mit einem Nanoindenter gemessen wurden, wie in der Beschreibung und Figur 4 offenbart.

12. Das Verfahren gemäß Anspruch 11, wobei das Lötmaterial ferner C enthält.

13. Das Verfahren gemäß Anspruch 11, wobei ein Massenverhältnis von Ag zu Cu im Lötmaterial 1,2 oder mehr und 1,7 oder weniger beträgt.

14. Das Verfahren gemäß Anspruch 11, wobei das aufgebrachte Lötmaterial eine Dicke von 10 µm oder mehr und 40 µm oder weniger aufweist.

15. Das Verfahren gemäß Anspruch 11, wobei das Keramikelement (2) eine Dreipunkt-Biegefestigkeit von 500 MPa oder mehr aufweist, wenn es gemäß JIS-R-1601 gemessen wird.

## Revendications

1. Corps joint comprenant :
un élément en céramique (2) ; et
une plaque de cuivre (31, 32) présentant une épaisseur de 0,3 mm ou plus jointe à l'élément en céramique (2) avec une couche de jonction (41, 42) entre elles, dans lequel :
la couche de jonction (41, 42) comporte un matériau de brasage,
le matériau de brasage contient Ag, Cu, Ti et au moins un élément sélectionné dans le groupe consistant en Sn et In,
un rapport massique de Ag sur Cu dans la couche de jonction (41, 42) est de 2,1 ou moins,
une teneur en Ti dans la couche de jonction (41, 42) est de 5 % en masse ou plus,
une teneur en au moins un élément sélectionné parmi Sn et In dans la couche de jonction (41, 42) est de 5 % en masse ou plus et de 20 % en masse ou moins,
la couche de jonction (41, 42) contient un cristal de Ag-Ti,
la couche de jonction (41, 42) donne un diagramme de diffraction des rayons X présentant un rapport d'intensité (I_{AgTi}/I_{Ag}) d'un pic maximal attribué au cristal de Ag-Ti (I_{AgTi}) par rapport à un pic maximal attribué à un cristal de Ag (I_{Ag}) de 0,5 ou plus et de 1,2 ou moins dans une plage de 37,5 degrés à 38,5 degrés du diagramme de diffraction des rayons X, et
une dureté par nanoindentation H_{IT} de la couche de jonction (41, 42) est de 1,0 GPa ou plus et de 2,5 GPa ou moins, la dureté par nanoindentation H_{IT} de la couche de jonction (41, 42) étant définie par une valeur moyenne de trois duretés par nanoindentation mesurées respectivement à trois endroits différents le long d'une partie centrale d'une section transversale de la couche de jonction, les trois duretés par nanoindentation de la couche de jonction (41, 42) étant mesurées par un dispositif de nanoindentation, comme divulgué dans la description et sur la figure 4,
la plaque de cuivre (31, 32) présente une région qui est à 100 µm dans une direction d'épaisseur de la plaque de cuivre (31, 32) à partir de l'interface entre la plaque de cuivre (31, 32) et la couche de jonction (41, 42), et
la différence entre la dureté par nanoindentation H_{IT} de la couche de jonction (41, 42) et une dureté par nanoindentation H_{IT} de la région est de 0,5 GPa ou moins, la dureté par nanoindentation H_{IT} de la région étant définie par une valeur moyenne de trois duretés par nanoindentation mesurées respectivement à trois endroits différents d'une section transversale de la région, les trois duretés par nanoindentation de la région étant mesurées par un dispositif de nanoindentation, comme divulgué dans la description et sur la figure 4.

2. Corps joint selon la revendication 1, dans lequel l'élément en céramique (2) est un substrat en nitrure de silicium présentant une épaisseur de 0,4 mm ou moins.

3. Corps joint selon la revendication 1, dans lequel la plaque de cuivre (31, 32) présente une épaisseur de 0,7 mm ou plus.

4. Corps joint selon la revendication 1, dans lequel la plaque de cuivre (31, 32) présente une dureté Vickers Hᵥ de 100 ou moins, lorsqu'elle est mesurée selon le JIS-R-1610.

5. Corps joint selon la revendication 1, dans lequel l'élément en céramique (2) présente une résistance à la flexion en trois points de 500 MPa ou plus, lorsqu'elle est mesurée selon le JIS-R-1601.

6. Corps joint selon la revendication 1, dans lequel la couche de jonction (41, 42) contient en outre un cristal de TiC.

7. Corps joint selon la revendication 1, dans lequel : le matériau de brasage contient en outre du C.

8. Corps joint selon la revendication 1, comprenant en outre une pluralité des plaques de cuivre (31, 32).

9. Carte de circuit imprimé comprenant le corps joint selon la revendication 1.

10. Dispositif semi-conducteur comprenant :
la carte de circuit imprimé selon la revendication 9 ; et
un élément semi-conducteur sur la plaque de cuivre (31, 32)

11. Procédé de fabrication d'un corps joint, le procédé comprenant les étapes suivantes :
l'application d'un matériau de brasage sur un élément en céramique (2) et le placement d'une plaque de cuivre (31, 32) présentant une épaisseur de 0,3 mm ou plus sur le matériau de brasage, le matériau de brasage contenant Ag, Cu, Ti et au moins un élément sélectionné dans le groupe consistant en Sn et In, un rapport massique de Ag sur Cu dans le matériau de brasage étant de 2,1 ou moins, une teneur en Ti dans le matériau de brasage étant de 5 % en masse ou plus, et une teneur en au moins un élément sélectionné parmi Sn et In dans le matériau de brasage étant de 5 % en masse ou plus et de 20 % en masse ou moins ; et
la réalisation d'une liaison thermique de l'élément en céramique (2) et de la plaque de cuivre (31, 32) avec le matériau de brasage à une température de 700 °C ou plus et de 900 °C ou moins pendant 30 minutes ou plus, une pression de 1 × 10⁻³ Pa ou moins, et sous une atmosphère non oxydante, afin de former une couche de jonction (41, 42) reliant l'élément en céramique (2) et la plaque de cuivre (31, 32), dans lequel :
la couche de jonction (41, 42) contient un cristal de Ag-Ti,
la couche de jonction (41, 42) donne un diagramme de diffraction des rayons X présentant un rapport d'intensité (I_{AgTi}/I_{Ag}) d'un pic maximal attribué au cristal de Ag-Ti (I_{AgTi}) par rapport à un pic maximal attribué à un cristal de Ag (I_{Ag}) de 0,5 ou plus et de 1,2 ou moins dans une plage de 37,5 degrés à 38,5 degrés du diagramme de diffraction des rayons X, et
une dureté par nanoindentation HIT de la couche de jonction (41, 42) est de 1,0 GPa ou plus et de 2,5 GPa ou moins, la dureté par nanoindentation H_{IT} de la couche de jonction (41, 42) étant définie par une valeur moyenne de trois duretés par nanoindentation mesurées respectivement à trois endroits différents le long d'une partie centrale d'une section transversale de la couche de jonction, les trois duretés par nanoindentation de la couche de jonction (41, 42) étant mesurées par un dispositif de nanoindentation, comme divulgué dans la description et sur la figure 4,
la plaque de cuivre (31, 32) présente une région qui est à 100 µm dans une direction d'épaisseur de la plaque de cuivre (31, 32) à partir de l'interface entre la plaque de cuivre (31, 32) et la couche de jonction (41, 42), et
la différence entre la dureté par nanoindentation H_{IT} de la couche de jonction (41, 42) et une dureté par nanoindentation H_{IT} de la région est de 0,5 GPa ou moins, la dureté par nanoindentation H_{IT} de la région étant définie par une valeur moyenne de trois duretés par nanoindentation mesurées respectivement à trois endroits différents d'une section transversale de la région, les trois duretés par nanoindentation de la région étant mesurées par un dispositif de nanoindentation, comme divulgué dans la description et sur la figure 4.

12. Procédé selon la revendication 11, dans lequel le matériau de brasage contient en outre du C.

13. Procédé selon la revendication 11, dans lequel un rapport massique de Ag sur Cu dans le matériau de brasage est de 1,2 ou plus et de 1,7 ou moins.

14. Procédé selon la revendication 11, dans lequel le matériau de brasage appliqué présente une épaisseur de 10 µm ou plus et de 40 µm ou moins.

15. Procédé selon la revendication 11, dans lequel l'élément en céramique (2) présente une résistance à la flexion en trois points de 500 MPa ou plus, mesurée selon le JIS-R-1601.
